(19) Europäisches Patentamt
European Patent Office
Office européen des brevets

(11) **EP 2 562 567 A1**

(12) **DEMANDE DE BREVET EUROPEEN**

(43) Date de publication:
**27.02.2013 Bulletin 2013/09**

(51) Int Cl.:
***G02B 1/11*** *(2006.01)* ***B82Y 20/00*** *(2011.01)*

(21) Numéro de dépôt: **12181046.9**

(22) Date de dépôt: **20.08.2012**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **24.08.2011 FR 1157505**

(71) Demandeur: **Commissariat à l'Énergie Atomique et aux Énergies Alternatives 75015 Paris (FR)**

(72) Inventeurs:
• **Surana, Kavita**
  **New Delhi - 110070 (IN)**
• **Baudrit, Mathieu**
  **73000 Chambery (FR)**
• **Mur, Pierre**
  **38920 Crolles (FR)**
• **Thony, Philippe**
  **38380 Entre-Deux-Guiers (FR)**

(74) Mandataire: **Ilgart, Jean-Christophe et al BREVALEX 95 rue d'Amsterdam 75378 Paris Cedex 8 (FR)**

(54) **Procede de realisation d'un reflecteur optique a nanocristaux de semi-conducteur**

(57) Procédé de réalisation d'un réflecteur optique (100) comportant un empilement alterné d'au moins une première couche (110) d'indice de réfraction complexe $n_1$ et d'au moins une deuxième couche (106) d'indice de réfraction complexe $n_2$, dans lequel la première couche comporte des nanocristaux de semiconducteur (108), comportant les étapes de :
- calcul du nombre total de couches de l'empilement, des épaisseurs de chacune des couches et des valeurs des indices de réfraction complexes $n_1$ et $n_2$ à partir des caractéristiques d'une fenêtre spectrale de réflectivité souhaitée du réflecteur optique, comportant la mise en oeuvre d'une méthode de calcul de matrices de transfert optique ;
- calcul de paramètres de dépôt et de recuit des couches à partir du nombre total de couches, des épaisseurs des couches et des valeurs des indices de réfraction complexes $n_1$ et $n_2$ précédemment calculés ;
- dépôt et recuit des couches conformément aux paramètres précédemment calculés.

FIG.1B

EP 2 562 567 A1

**Description**

**DOMAINE TECHNIQUE**

L'invention concerne un procédé de réalisation d'un réflecteur optique par exemple de type réflecteur de Bragg distribué, également appelé réseau de Bragg ou miroir de Bragg, comportant notamment des nanocristaux de semi-conducteur modulant les indices optiques, c'est-à-dire l'indice de réfraction complexe, d'une ou plusieurs couches de matériaux du réflecteur optique.

Un tel réflecteur optique est avantageusement utilisé dans le domaine des dispositifs semi-conducteurs, comme par exemple les lasers, les LED (diodes électroluminescentes) et d'autres applications optoélectroniques. Un tel réflecteur optique est également avantageusement utilisé dans le domaine photovoltaïque pour former par exemple une structure antireflet destinée à être disposée en face avant d'une cellule photovoltaïque, ou encore une structure réflective destinée à être disposée en face arrière de la cellule photovoltaïque.

**ÉTAT DE LA TECHNIQUE ANTÉRIEURE**

Un réflecteur de Bragg distribué (RBD), ou réseau de Bragg, est un réflecteur optique comportant un empilement de matériaux formant une alternance de couches de matériaux d'indices de réfraction complexes différents. Lorsque le réflecteur reçoit de la lumière, des interférences se produisent au sein du réflecteur, ces interférences étant fonction de la différence entre les indices de réfraction complexes des matériaux des couches du réflecteur, du nombre et des épaisseurs de ces couches, ainsi que des caractéristiques optiques des matériaux se trouvant autour de l'empilement.

Un RBD est défini par sa réflectivité en fonction de la longueur d'onde reçue. Cette réflectivité se caractérise notamment par une fenêtre spectrale de réflectivité, ou bande de coupure photonique, c'est-à-dire une gamme de longueurs d'ondes pour laquelle le RBD présente une réflectivité maximale par rapport aux autres longueurs d'ondes.

Les RBD sont généralement réalisés à partir de matériaux semi-conducteurs de type III-V, ou combinant par exemple du $SiO_2$ ou du $Si_3N4$ avec du silicium amorphe ou cristallin en raison de leur différence d'indices de réfraction complexes. Les documents WO 2005/064394 A1 et US 2002/0163003 A1 décrivent par exemple de tels RBD.

Ces RBD ont toutefois pour inconvénient d'être couteux à réaliser. De plus, les fenêtres spectrales de réflectivité de ces RBD sont difficilement ajustables car pour changer les indices de réfraction complexes des couches, il peut être nécessaire de changer les matériaux des couches car chaque matériau présente un indice de réfraction déterminé et de valeur constante dans les cas de matériaux stoechiométriques.

**EXPOSÉ DE L'INVENTION**

Un but de la présente invention est de proposer un nouveau procédé de réalisation d'un réflecteur optique, formant par exemple un réflecteur de Bragg distribué, permettant d'ajuster aisément la fenêtre spectrale de réflectivité du réflecteur réalisé, et cela sans augmenter les coûts liés à sa réalisation.

Pour cela, la présente invention propose un procédé de réalisation d'un réflecteur optique comportant au moins un empilement alterné d'au moins une première couche d'indice de réfraction complexe $n_1$ et d'au moins une deuxième couche d'indice de réfraction complexe $n_2$ différent de l'indice de réfraction complexe $n_1$, dans lequel la première couche comporte des nanocristaux de semi-conducteur, comportant au moins les étapes de :

- calcul du nombre total de couches de l'empilement, des épaisseurs de chacune des couches de l'empilement et des valeurs des indices de réfraction complexes $n_1$ et $n_2$ à partir des caractéristiques d'une fenêtre spectrale de réflectivité souhaitée du réflecteur optique, comportant la mise en oeuvre d'une méthode de calcul de matrices de transfert optique ;
- calcul de paramètres de dépôt et de recuit des couches de l'empilement à partir du nombre total de couches de l'empilement, des épaisseurs des couches de l'empilement et des valeurs des indices de réfraction complexes $n_1$ et $n_2$ précédemment calculés ;
- dépôt et recuit des couches de l'empilement conformément aux paramètres précédemment calculés.

Un tel réflecteur optique comporte au moins deux couches distinctes disposées l'une au-dessus de l'autre, d'indices de réfraction complexes différents et dont les épaisseurs sont adaptées à la réalisation d'un réflecteur optique par exemple de type RBD. Au moins l'une des deux couches comporte des nanocristaux de semi-conducteur modulant l'indice de réfraction complexe $n_1$ de la ou des premières couches du réflecteur optique.

Ainsi, en modulant le nombre de couches formant l'empilement, les épaisseurs de ces couches et les indices de réfraction complexes de ces couches, on peut construire un réflecteur optique dont la fenêtre spectrale de réflectivité est facilement ajustable grâce à l'utilisation des nanocristaux de semi-conducteur qui permettent d'ajuster l'indice de

réfraction complexe $n_1$ de la ou des premières couches en ajustant notamment la densité de nanocristaux de semi-conducteur réalisés dans la ou les premières couches.

Lorsque l'empilement est disposé sur un substrat par exemple composé de silicium, le réflecteur optique permet de choisir les longueurs d'ondes qui seront absorbées ou non par l'empilement, ce qui permet d'accentuer l'absorption lumineuse dans les couches du réflecteur optique et minimiser l'absorption lumineuse réalisée par le substrat.

De plus, lorsque l'empilement comporte une couche supérieure (couche disposée au sommet de l'empilement) et une couche inférieure (couche formant la base de l'empilement, sur laquelle reposent les autres couches de l'empilement) correspondant à des premières couches comportant des nanocristaux de semi-conducteur, ces couches supérieure et inférieure peuvent être électriquement conductrices compte tenu de la présence des nanocristaux de semi-conducteur présents dans ces couches, et peuvent donc être utilisées en tant qu'électrodes.

Un tel procédé ne nécessite pas de faire appel à des équipements complexes, et peut faire appel à des équipements standards compatibles avec la technologie MOS.

La première et la deuxième couche peuvent comporter chacune une épaisseur comprise entre environ 10 nm et 500 nm, ou entre environ 1 nm et plusieurs micromètres. L'épaisseur de chacune des couches peut être égale à

environ $\dfrac{\lambda}{4n}$, avec $\lambda$ correspondant à la longueur d'onde centrale de la fenêtre spectrale de réflectivité souhaité, et n correspondant à l'indice de réfraction (partie réelle) du matériau de la couche.

Les nanocristaux de semi-conducteur peuvent être composés de silicium amorphe ou cristallin, et/ou la première et/ou la deuxième couche peuvent comporter du dioxyde de silicium et/ou de l'oxyde de silicium et/ou du nitrure de silicium et/ou de l'oxynitrure de silicium et/ou du carbure de silicium. Ainsi, il est possible de réaliser un réflecteur optique entièrement composé de matériaux à base de silicium, facilitant sa réalisation lorsqu'il est destiné à être couplé avec des dispositifs optoélectroniques composés de silicium tels que des lasers, des LED ou tout autre dispositif optoélectronique.

Un tel réflecteur optique peut comporter avantageusement des nanocristaux de silicium amorphe ou cristallin disposés dans une matrice à base de silicium et par exemple composée de $SiO_2$.

La deuxième couche d'indice de réfraction complexe $n_2$ peut comporter des nanocristaux de semi-conducteur. Il est possible que toutes les couches de l'empilement du réflecteur optique comportent des nanocristaux de semi-conducteur. Ainsi, il est possible d'avoir un réflecteur optique dont l'empilement de couches est électriquement conducteur. Dans ce cas, la conductivité des couches peut être aisément contrôlée en faisant varier le nombre et la densité de nanocristaux de semi-conducteur dans les couches de l'empilement.

L'empilement peut comporter m premières couches d'indice de réfraction complexe $n_1$ et m-1 deuxièmes couches d'indice de réfraction complexe $n_2$ disposées de manière alternée les unes au-dessus des autres, m étant un nombre entier supérieur ou égal à 2.

La fenêtre spectrale de réflectivité du réflecteur optique réalisé peut être contrôlée à travers le contrôle du nombre de couches de l'empilement, des épaisseurs des couches et des indices optiques des couches. Cela est obtenu notamment en contrôlant la densité de nanocristaux de semi-conducteur formés dans la ou les premières couches.

Le calcul des paramètres de dépôt et de recuit des couches de l'empilement peut être mis en oeuvre, pour chaque couche, à partir des valeurs des indices de réfraction complexes et des épaisseurs des couches obtenues en fonction de différents paramètres de dépôt et de recuit. Les paramètres de dépôt peuvent correspondre à une pression à laquelle les dépôts de couche sont mis en oeuvre, et/ou un débit gazeux de $SiH_4$ et/ou un rapport de débits gazeux de $N_2O$ et de $SiH_4$ lors des dépôts des couches, et/ou une durée des dépôts et/ou de la puissance de l'équipement de dépôt utilisé.

Lors du dépôt des couches de l'empilement, la ou les premières couches de l'empilement peuvent être réalisées telles qu'elles comportent en excès le semi-conducteur destiné à former les nanocristaux, le recuit pouvant être mis en oeuvre ultérieurement aux dépôts et pouvant former, dans la ou les premières couches, les nanocristaux de semi-conducteur par précipitation à l'état solide du semi-conducteur présent en excès dans la ou les premières couches déposées avant le recuit.

On peut donc contrôler le nombre de nanocristaux dans la ou les premières couches en contrôlant l'enrichissement ou l'excès de semi-conducteur dans les premières couches déposées et en contrôlant les conditions de recuit. Ainsi, on peut aisément contrôler les indices optiques (parties réelles et imaginaires des indices de réfraction complexes) en faisant varier les conditions de recuit mais également la quantité de semi-conducteur en excès lors du dépôt des couches. Une seule étape de recuit peut être mise en oeuvre pour former les nanocristaux dans toutes les premières couches. Il est également possible de réaliser un recuit entre chaque dépôt d'une première couche.

La méthode de calcul de matrices de transfert optique peut comporter les étapes de :

    a) choix de valeurs arbitraires du nombre total de couches de l'empilement, des épaisseurs de chacune des couches de l'empilement et des valeurs des indices de réfraction complexes $n_1$ et $n_2$,

b) calcul, pour chaque couche de l'empilement et pour chaque longueur d'onde de la fenêtre spectrale de réflectivité souhaitée, d'une matrice de transfert optique,

c) calcul d'un produit matriciel des matrices de transfert optique précédemment calculées pour chacune des couches à l'étape b), correspondant à la matrice de transfert optique de l'empilement de couches,

d) calcul de la réflectivité de l'empilement pour chaque longueur d'onde de la fenêtre spectrale de réflectivité souhaitée,

e) comparaison de la réflectivité calculée à l'étape d) et de la fenêtre spectrale de réflectivité souhaitée,

les étapes b) à e) étant répétées pour des valeurs différentes du nombre total de couches de l'empilement, des épaisseurs de chacune des couches de l'empilement et des indices de réfraction complexes $n_1$ et $n_2$ lorsque la réflectivité calculée à l'étape d) ne correspond pas à la fenêtre spectrale de réflectivité souhaitée.

Les paramètres de dépôt et de recuit des couches de l'empilement peuvent être calculés également à partir des valeurs des coefficients d'extinction des couches.

L'invention concerne également un procédé de réalisation d'une cellule photovoltaïque comportant la mise en oeuvre d'un procédé de réalisation d'au moins un premier réflecteur optique tel que décrit précédemment disposé en face avant de la cellule photovoltaïque et formant une structure anti-réflective, et/ou la mise en oeuvre d'un procédé de réalisation d'au moins un deuxième réflecteur optique tel que décrit précédemment disposé en face arrière de la cellule photovoltaïque et formant une structure réflective.

**BRÈVE DESCRIPTION DES DESSINS**

La présente invention sera mieux comprise à la lecture de la description d'exemples de réalisation donnés à titre purement indicatif et nullement limitatif en faisant référence aux dessins annexés sur lesquels :

- les figures 1A et AB représentent des étapes d'un procédé de réalisation d'un réflecteur optique, objet de la présente invention, selon un mode de réalisation particulier ;
- la figure 2 représente des fenêtres spectrales de réflectivité mesurées et simulées de réflecteurs optiques, objets de la présente invention ;
- la figure 3 représente une cellule photovoltaïque comportant des réflecteurs optiques, objets de la présente invention ;
- la figure 4 représente les étapes d'une méthode de calcul des matrices de transfert optique mises en oeuvre lors d'un procédé de réalisation d'un réflecteur optique, objet de la présente invention ;
- la figure 5 représente une courbe de variation de l'indice de réfraction d'une couche déposée par PECVD en fonction d'un rapport de débits gazeux de $N_2O$ et de $SiH_4$ lors du dépôt de cette couche.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

**EXPOSÉ DÉTAILLÉ DE MODES DE RÉALISATION PARTICULIERS**

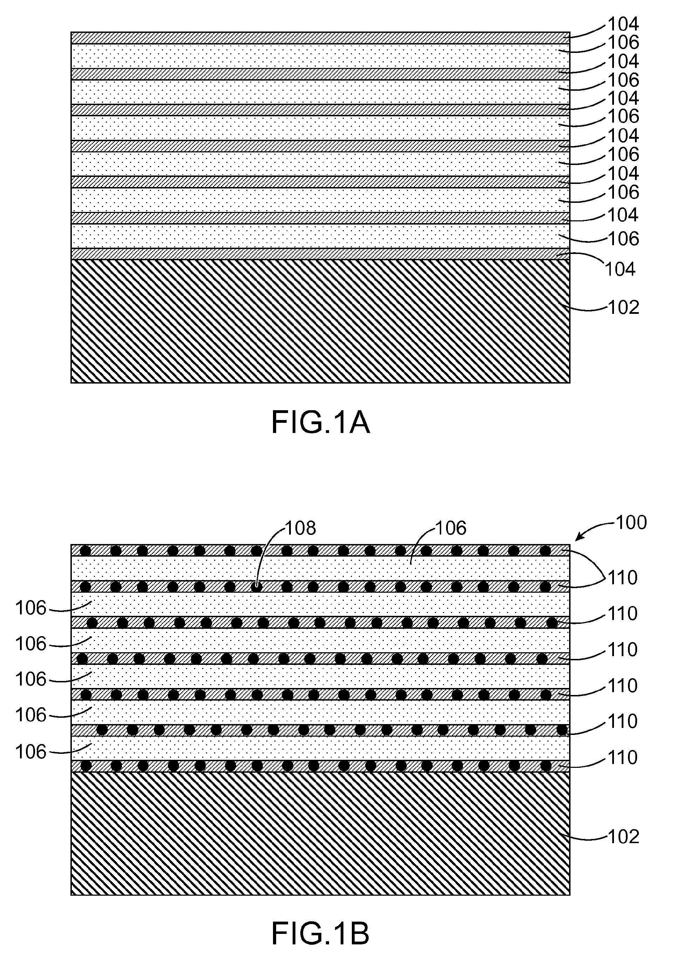

On se réfère tout d'abord aux figures 1A et 1B qui représentent des étapes d'un procédé de réalisation d'un réflecteur optique 100 selon un mode de réalisation particulier.

On réalise sur un substrat 102 par exemple composé de silicium, un empilement alterné de premières couches 104 composées de dioxyde de silicium riche en silicium (ou $SiO_2$ sous-stoechiométrique) et de deuxièmes couches 106 composées de $SiO_2$ stoechiométrique. Sur l'exemple de la figure 1A, la couche inférieure (celle en contact avec le substrat 102 et sur laquelle sont disposées les autres couches de l'empilement) et la couche supérieure (celle disposée au sommet de l'empilement) sont des premières couches 104. Les couches 104 et 106 de cet empilement sont par exemple déposées par PECVD (dépôt chimique en phase vapeur assisté par plasma) avec des épaisseurs différentes.

L'épaisseur de chaque couche est fonction de l'indice de réfraction du ou des matériaux de la couche ainsi que des longueurs d'ondes destinées à être réfléchies. De manière générale, chaque couche 104, 106 peut avoir une épaisseur comprise entre environ 10 nm et 500 nm, ou comprise entre environ 1 nm et plusieurs micromètres, en fonction des longueurs d'ondes de la fenêtre spectrale de réflectivité souhaitée du réflecteur optique 100. Dans un exemple particulier, l'épaisseur de chacune des couches 104, 106 peut être égale à environ $\dfrac{\lambda}{4n}$, avec $\lambda$ correspondant à la longueur d'onde centrale de la fenêtre spectrale de réflectivité souhaitée, et n correspondant à l'indice de réfraction (partie réelle) du matériau de la couche.

L'empilement ainsi réalisé subit ensuite un recuit à une température par exemple inférieure ou égale à environ 1300°C pendant une durée comprise entre environ quelques secondes et plusieurs heures (par exemple 3 heures). Ce recuit entraine une densification des couches 104 et 106 et, dans les premières couches 104, une séparation du $SiO_2$ stoechiométrique et de l'excédent de silicium initialement présent dans les premières couches 104. Ce silicium en excès se précipite à l'état solide en formant des nanocristaux 108 disposés dans une matrice diélectrique correspondant au $SiO_2$ issu des couches 104. On obtient ainsi des premières couches 110 composées de $SiO_2$ et comportant des nano-cristaux de silicium 108.

Dans chacune des premières couches 110, les nanocristaux 108 peuvent avoir des dimensions différentes ou non. Ainsi, lorsque les premières couches 104 ont chacune une épaisseur inférieure à environ 8 nm, les nanocristaux de silicium 108 obtenus à partir de ces premières couches 104 ont des dimensions sensiblement similaires les uns par rapport aux autres. Par contre, lorsque les premières couches 104 ont chacune une épaisseur supérieure ou égale à environ 8 nm, les nanocristaux de silicium 108 obtenus peuvent avoir des dimensions différentes les uns par rapport aux autres. Les nanocristaux 108 ont par exemple chacun un diamètre compris entre environ 1 nm et 20 nm. Dans le réflecteur optique 100, les indices de réfraction complexes $n_1$ des premières couches 110 sont fonction notamment de la densité et de la distribution des nanocristaux 108 dans les premières couches 110, et donc également de la quantité de silicium en excès dans les couches 104, des conditions de recuit et de l'épaisseur des couches 104 à partir desquelles sont obtenues les premières couches 110.

On obtient ainsi le réflecteur optique 100 qui forme un réflecteur de Bragg distribué, disposé sur le substrat 102 et comportant un empilement alterné de premières couches 110 d'indice de réfraction complexe $n_1$ et de deuxièmes couches d'indice de réfraction complexe $n_2$ différent de l'indice de réfraction complexe $n_1$. Dans le réflecteur optique 100 obtenu, les deuxièmes couches 106 forment des couches diélectriques isolant électriquement les premières couches 110 qui comportent les nanocristaux de semi-conducteur 108 et qui sont donc électriquement conductrices. Les valeurs des parties réelles des indices de réfraction complexes $n_1$ et $n_2$ peuvent être par exemple comprises entre environ 1,4 et 4,5 (à une longueur d'onde égale à 632,8 nm).

Le nombre total de couches 104 et 106, leurs épaisseurs et indices optiques, ainsi que les matériaux utilisés pour réaliser le réflecteur optique 100, dépendront de la fenêtre spectrale de réflectivité du réflecteur optique 100 que l'on cherche à obtenir.

Ainsi, pour réaliser le réflecteur optique 100, on caractérise tout d'abord la fenêtre spectrale de réflectivité souhaitée : gamme de longueurs d'ondes que le réflecteur optique 100 est destiné à réfléchir et taux de réflectivité souhaité pour cette gamme de longueurs d'ondes. Les longueurs d'ondes considérées sont par exemple comprises entre environ 300 nm et 1200 nm.

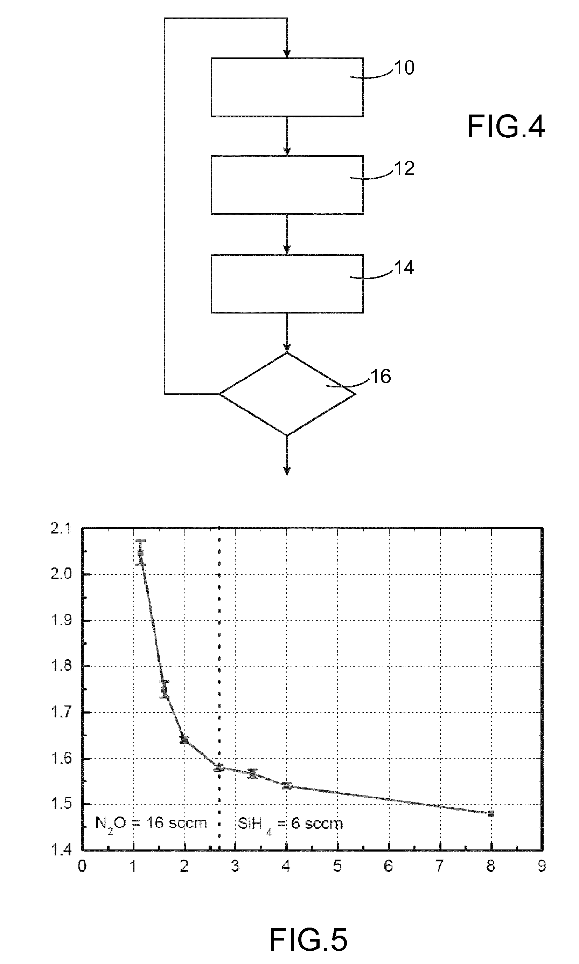

On applique ensuite la méthode de calcul des matrices de transfert optique afin de déterminer le nombre de couches 104 et 106 nécessaires, les épaisseurs de ces couches 104 et 106 ainsi que les valeurs des indices de réfraction complexes $n_1$ et $n_2$ que doivent avoir chacune de ces couches pour obtenir le réflecteur optique 100 présentant la fenêtre spectrale de réflectivité souhaitée. Un exemple de mise en oeuvre de la méthode de calcul des matrices de transfert optique est détaillé ci-dessous en liaison avec le diagramme représenté sur la figure 4.

On choisit tout d'abord des valeurs arbitraires des paramètres que l'on souhaite déterminer, c'est-à-dire du nombre de couches 104 et 106, des épaisseurs de ces couches 104 et 106 ainsi que des indices de réfraction complexes $n_1$ et $n_2$.

On calcul ensuite (étape 10), pour chaque couche et pour chaque longueur d'onde $\lambda$ de la fenêtre spectrale de réflectivité souhaitée, une matrice M de transfert optique telle que :

$$\begin{bmatrix} E(0) \\ H(0) \end{bmatrix} = M \begin{bmatrix} E(d) \\ H(d) \end{bmatrix},$$

avec E et H correspondant aux composantes tangentielles des champs électriques et magnétiques dans la couche, d correspondant aux coordonnées optiques à travers l'épaisseur de la couche.

La matrice M correspond à :

$$M = \begin{bmatrix} \cos\varphi & j\sin\varphi/Y \\ jY\sin\varphi & \cos\varphi \end{bmatrix},$$

avec $\varphi = \dfrac{2\pi}{\lambda}nd\cos\Theta$,

$\varphi$ représentant le déphasage de la lumière se propageant à travers la couche, n correspondant à l'indice de réfraction complexe de la couche, et $\Theta$ l'angle d'incidence attendu de la lumière par rapport à la couche (par exemple égal à 90°).

Y est l'admittance optique de la couche qui est égale à, pour les polarisations parallèle (p ou TE) et perpendiculaire (s ou TM) :

$$Y^{(s)} = \sqrt{\frac{\varepsilon_0}{\mu_0}}n\cos\Theta$$

$$Y^{(p)} = \sqrt{\frac{\varepsilon_0}{\mu_0}}n/\cos\Theta$$

où $\varepsilon_0$ et $\mu_0$ sont la permittivité et la perméabilité du vide.

On calcule ensuite (étape 12) la matrice du système complet, c'est-à-dire de l'empilement de couches, pour chaque longueur d'onde $\lambda$, correspondant au produit matriciel des matrices M de chaque couche.

A partir de cette matrice de transfert optique du système complet, on peut alors calculer (étape 14), pour chaque longueur d'onde $\lambda$, la réflectivité r du système telle que :

$$r = \frac{Y_0 M_{11} + Y_0 Y_S M_{12} + M_{21} - Y_S M_{22}}{Y_0 M_{11} + Y_0 Y_S M_{12} + M_{21} + Y_S M_{22}}$$

$M_{ab}$ correspondant au coefficient de la ligne a et de la colonne b de la matrice M.

La réflectivité r obtenue est comparée à la fenêtre spectrale de réflectivité souhaitée (étape 16).

Si la réflectivité r obtenue ne correspond pas à la fenêtre spectrale de réflectivité souhaitée, on modifie alors les paramètres initialement choisis de manière arbitraire (épaisseurs et/ou indices optiques et/ou nombre de couches), et les calculs sont réitérés jusqu'à obtenir un système dont la réflectivité calculée correspond à la fenêtre spectrale de réflectivité souhaitée, signifiant que les paramètres choisis sont corrects.

A partir des paramètres précédemment calculés, ainsi que des valeurs des coefficients d'extinction des différentes couches (données connues ou calculées ou mesurées par exemple par ellipsométrie spectroscopique), on détermine alors les paramètres liés à la mise en oeuvre des dépôts de ces couches ainsi que les paramètres du ou des recuits réalisés ensuite.

Ainsi, pour des couches composées par exemple de $SiO_2$ destinées à être déposées par PECVD, l'épaisseur des couches à réaliser sera fonction des débits gazeux de $N_2O$, de $SiH_4$, de la pression lors du dépôt et de la puissance de l'équipement de dépôt utilisé, et également de la durée de mise en oeuvre du dépôt. Il convient de noter également que la valeur de l'indice de réfraction complexe de la couche obtenue est principalement dépendante (à près de 90%) de la pression et du débit de $SiH_4$ lors du dépôt.

On peut notamment utiliser pour cela des données (courbes ou tableaux de valeurs), obtenues expérimentalement ou par simulation, donnant les valeurs des indices de réfraction et des épaisseurs des couches obtenues en fonction de ces différents paramètres de dépôt et de recuit. La figure 5 représente par exemple une telle courbe, donnant la valeur de l'indice de réfraction (à une longueur d'onde de 633 nm) d'une couche de $SiO_2$ déposée par PECVD en fonction du rapport de débits gazeux de $N_2O$ et de $SiH_4$ lors du dépôt de cette couche.

A partir des paramètres de mise en oeuvre de dépôts et de recuit calculés, on peut donc ensuite mettre en oeuvre les étapes de dépôt et de recuit pour réaliser le réflecteur optique 100, comme décrit précédemment en liaison avec les figures 1A et 1B.

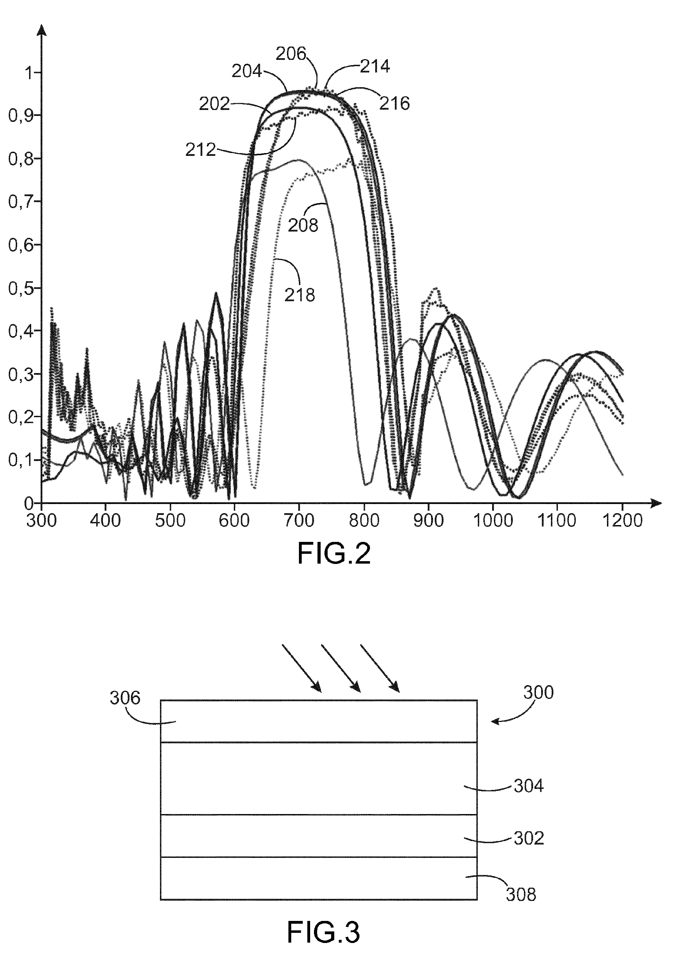

Les courbes 202, 204 et 206 représentées sur la figure 2 correspondent à des résultats de simulation de la réflectivité du réflecteur optique 100 pour différents recuits. Pour ces simulations, les premières couches 104 sont composées de $SiO_2$ riche en silicium et ont chacune une épaisseur égale à environ 83,2 nm (excepté la première couche 104 se trouvant contre le substrat 102 qui a une épaisseur égale à environ 80 nm). Les deuxièmes couches 106 sont composées de $SiO_2$ stoechiométrique et ont chacune une épaisseur égale à environ 126 nm. Le substrat 102 est composé de silicium.

La courbe 202 représente le cas où les couches 104 et 106 ont subies un unique recuit à environ 1000°C pendant 3 mn. L'indice de réfraction d'une seule des premières couches 110 obtenues comportant les nanocristaux de silicium 108, à une longueur d'onde d'environ 633 nm, est égal à environ 2,01. La courbe 204 représente le cas où les couches 104 et 106 ont subies un premier recuit à environ 1000°C pendant 3 mn, puis un deuxième recuit à environ 1180°C pendant 60 mn. L'indice de réfraction d'une seule des premières couches 110 obtenues comportant les nanocristaux de silicium 108, à une longueur d'onde d'environ 633 nm, est égal à environ 2,11. Enfin, la courbe 206 représente le cas où les couches 104 et 106 ont subies un unique recuit à environ 1180°C pendant 60 mn. L'indice de réfraction d'une seule des couches 110 obtenues comportant les nanocristaux 108, à une longueur d'onde d'environ 633 nm, est égal à environ 2,09.

A titre de comparaison, la courbe 208 correspond à la réflectivité d'un réflecteur optique comportant les mêmes couches 104 et 106 mais qui n'ont pas subies de recuit, ce réflecteur optique ne comportant donc pas de nanocristaux de silicium dans ses premières couches. L'indice de réfraction d'une seule des couches 104 de dioxyde de silicium enrichi en silicium, à une longueur d'onde d'environ 633 nm, est égal à environ 1,86.

On voit clairement, en comparant les courbes 202, 204 et 206 avec la courbe 208, que la mise en oeuvre d'un recuit permet d'élargir la fenêtre spectrale de réflectivité d'un réflecteur optique (augmentation de la gamme de longueurs d'ondes couverte par cette fenêtre spectrale de réflectivité) et également d'augmenter la valeur de la réflectivité du réflecteur optique dans la gamme des longueurs d'ondes de la fenêtre spectrale de réflectivité. Ceci est dû au fait que le recuit densifie les matériaux des couches de l'empilement, et forme les nanocristaux de semi-conducteur qui augmentent l'indice de réfraction des couches comportant ces nanocristaux. On voit également à partir des courbes 202, 204 et 206 que l'augmentation de la durée et de la température du recuit élargie la fenêtre spectrale de réflectivité obtenue et augmente la valeur de la réflectivité dans cette fenêtre spectrale, et cela en raison de modification des indices optiques après le recuit, à cause notamment de la formation des nanocristaux qui modifie les propriétés de réflectivité.

Les courbes 212 à 218 représentent des fenêtres spectrales de réflectivité mesurées du réflecteur optique 100 ayant subi différents recuits. Ces fenêtres spectrales de réflectivité sont mesurées par exemple par un spectrophotomètre. Un tel appareil envoie un faisceau lumineux incident, d'intensité connue et à différentes longueurs d'un spectre souhaité, sur le réflecteur optique, et mesure l'intensité de la lumière réfléchie à chacune des différentes longueurs d'ondes, ce qui permet de déterminer la réflectivité du réflecteur optique dans le spectre souhaité.

Les premières couches 104 sont composées de $SiO_2$ riche en silicium et ont chacune une épaisseur égale à environ 62,5 nm (excepté la première couche 104 se trouvant contre le substrat 102 qui a une épaisseur égale à environ 58,1 nm). Les deuxièmes couches 106 sont composées de $SiO_2$ stoechiométrique et ont chacune une épaisseur égale à environ 129,5 nm. Le substrat 102 est composé de silicium.

Ces courbes confirment bien l'agrandissement de la fenêtre spectrale de réflectivité obtenue ainsi que l'augmentation de la valeur de la réflectivité dans la gamme des longueurs d'ondes de cette fenêtre spectrale, lorsque l'on augmente la durée et/ou la température du recuit.

La fenêtre spectrale de réflectivité et l'intensité maximale de bande de cette fenêtre de réflectivité du réflecteur optique 100 dépend donc :

- de l'épaisseur totale de l'empilement de couches du réflecteur optique ;
- de l'épaisseur de chaque couche de l'empilement du réflecteur optique ;
- du nombre de couches de l'empilement du réflecteur optique ;
- des matériaux des couches de l'empilement, et notamment de celui dans lequel sont disposés les nanocristaux de semi-conducteur ;
- du semi-conducteur des nanocristaux ;
- de la densité des nanocristaux de semi-conducteur dans les premières couches ;
- des indices optiques (partie réelle de l'indice de réfraction complexe et partie imaginaire de l'indice de réfraction complexe appelée coefficient d'extinction) des couches de l'empilement ;
- de la différence des indices optiques des premières et deuxièmes couches de l'empilement.

Dans l'exemple précédemment décrit, les nanocristaux de semi-conducteur 108 son obtenus par une précipitation d'excès de semi-conducteur initialement présent dans les couches déposées. En variante, les nanocristaux de semi-conducteur peuvent être réalisés in-situ, c'est-à-dire lors du dépôt des couches et avant le ou les recuits, par exemple par CVD, LPCVD, évaporation, PECVD, pulvérisation, implantation, etc.

On peut envisager dans ce cas de ne pas réaliser de recuit des couches déposées.

Les premières couches 110 comportant les nanocristaux de semi-conducteur peuvent être composées d'au moins un matériau autre que du dioxyde de silicium, tel que de l'oxyde de silicium, du nitrure de silicium, de l'oxynitrure de silicium ou encore du carbure de silicium, déposé sous forme stoechiométrique ou sous-stoechiométrique selon que les nanocristaux de semi-conducteur soient réalisés in-situ ou non.

De plus, il est possible de réaliser un ou plusieurs recuits à des températures différentes et/ou sous des atmosphères différentes, soit après avoir déposé toutes les couches de l'empilement, soit entre ces étapes de dépôt.

Le réflecteur optique 100 précédemment décrit comporte une alternance de couches comportant ou non les nanocristaux 108. En variante, il est possible que toutes les couches de l'empilement du réflecteur optique 100 comportent des nanocristaux de semi-conducteur. Il convient dans ce cas de réaliser les couches 104 et 106 à partir de matériaux différents afin que le réflecteur optique 100 obtenu au final comporte bien un empilement formé d'une alternance de couches d'indices de réfraction complexes différents.

La présence de nanocristaux de semi-conducteur dans toutes les couches du réflecteur optique peut conférer au réflecteur optique des propriétés de conduction électrique et/ou de luminescence et/ou d'absorption lumineuse. Dans le cas de nanocristaux de semi-conducteur disposés dans des couches diélectriques, une conduction électrique peut notamment être obtenue lorsque la distance entre les nanocristaux est assez faible pour permettre de réaliser une conduction électrique par effet tunnel à travers ce matériau diélectrique.

Dans une autre variante, les différences d'indices de réfraction complexes au sein de l'empilement de couches du réflecteur optique peuvent ne pas être obtenues uniquement du fait que les couches 106 et 110 ont des indices optiques différents, mais du fait que chacune de ces couches comporte un indice optique variable, par exemple sous forme de gradient, au sein de la couche. Au sein d'une telle couche, l'indice de réfraction peut varier, dans le sens de l'épaisseur de la couche :

- en passant linéairement d'une première à une seconde valeur d'indice de réfraction ;
- en passant d'une première à une seconde valeur d'indice de réfraction sur une première moitié de l'épaisseur de la couche, puis en passant de la seconde à la première valeur d'indice de réfraction sur l'autre moitié de l'épaisseur de la couche ;
- en oscillant, le long de l'épaisseur de la couche, entre deux valeurs d'indice de réfraction différentes.

De telles couches peuvent être obtenues en faisant varier la composition du ou des matériaux utilisés pour former la couche (par exemple l'enrichissement en silicium) le long de son épaisseur.

La figure 3 représente une cellule photovoltaïque 300 comportant un substrat 302, par exemple composé de silicium de type p ou n et servant de support mécanique aux autres éléments de la cellule 300, et une ou plusieurs couches actives 304, par exemple composées de semi-conducteur de type n ou p, aptes à réaliser une conversion d'énergie photovoltaïque. La référence 304 désigne par exemple un empilement de trois couches composées de silicium amorphe dopées telles qu'elles forment un empilement p-i-n (par exemple une couche de silicium amorphe intrinsèque disposée entre une couche dopée p et une couche dopée n). La ou les couches 304 peuvent également être réalisées à partir de nanocristaux de semi-conducteur, de semi-conducteur amorphe, de semi-conducteur poreux, de semi-conducteur nanocristallin, de semi-conducteur polycristallin, etc. Le semi-conducteur actif de la ou des couches 304 et le substrat 302 forment une jonction p-n ou n-p.

La cellule photovoltaïque 300 comporte également en face avant (face de la cellule destinée à recevoir les rayons lumineux) un réflecteur optique 306 par exemple similaire au réflecteur optique 100 précédemment décrit, formant un réflecteur de Bragg distribué servant de revêtement anti-reflet à la cellule 300. Le réflecteur optique 306 est notamment réalisé tel que sa fenêtre spectrale de réflectivité permette de minimiser une réflexion lumineuse des rayons arrivant sur la face avant de la cellule photovoltaïque 300, et maximiser l'absorption des rayons lumineux par les couches actives 304. La cellule 300 comporte également en face arrière un deuxième réflecteur optique 308, également similaire au réflecteur optique 100 précédemment décrit, et configuré pour refléter les rayons lumineux incidents vers les couches actives 304 afin de maximiser l'efficacité de conversion photovoltaïque de la cellule 300. Les paramètres des réflecteurs optiques 306 et 308 (nombre de couches, matériaux utilisés, indices optiques des différentes couches) sont choisis en fonction de leurs rôles.

L'utilisation des réflecteurs optiques 306 et 308 permet de réaliser entièrement la cellule photovoltaïque 300 à partir du même semi-conducteur, ici du silicium.

En variante, la cellule photovoltaïque 300 peut ne comporter qu'un seul des deux réflecteurs optiques 306 et 308.

Les différentes variantes précédemment décrites pour le réflecteur optique 100 peuvent être réalisées pour l'un et/ou l'autre des réflecteurs optiques 306 et 308. En variante, il est également possible que la face avant de la cellule photovoltaïque 300 (et donc le réflecteur optique 306) présente un relief (ou texturation) favorisant l'absorption lumineuse dans la cellule 300. La cellule photovoltaïque 300 peut être du type à homojonction ou à hétérojonction.

**Revendications**

1. Procédé de réalisation d'un réflecteur optique (100, 306, 308) comportant au moins un empilement alterné d'au moins une première couche (110) d'indice de réfraction complexe $n_1$ et d'au moins une deuxième couche (106) d'indice de réfraction complexe $n_2$ différent de l'indice de réfraction complexe $n_1$, dans lequel la première couche (110) comporte des nanocristaux de semi-conducteur (108), comportant au moins les étapes de :

   - calcul du nombre total de couches (106, 110) de l'empilement, des épaisseurs de chacune des couches (106, 110) de l'empilement et des valeurs des indices de réfraction complexes $n_1$ et $n_2$ à partir des caractéristiques d'une fenêtre spectrale de réflectivité souhaitée du réflecteur optique (100, 306, 308), comportant la mise en oeuvre d'une méthode de calcul de matrices de transfert optique ;
   - calcul de paramètres de dépôt et de recuit des couches (104, 106) de l'empilement à partir du nombre total de couches (106, 110) de l'empilement, des épaisseurs des couches (106, 110) de l'empilement et des valeurs des indices de réfraction complexes $n_1$ et $n_2$ précédemment calculés ;
   - dépôt et recuit des couches (104, 106) de l'empilement conformément aux paramètres précédemment calculés.

2. Procédé selon la revendication 1, dans lequel les nanocristaux de semi-conducteur (108) sont composés de silicium amorphe ou cristallin, et/ou dans lequel la première (110) et/ou la deuxième couche (106) comportent du dioxyde de silicium et/ou de l'oxyde de silicium et/ou du nitrure de silicium et/ou de l'oxynitrure de silicium et/ou du carbure de silicium.

3. Procédé selon l'une des revendications précédentes, dans lequel la deuxième couche (106) d'indice de réfraction complexe $n_2$ comporte des nanocristaux de semi-conducteur.

4. Procédé selon l'une des revendications précédentes, dans lequel l'empilement comporte m premières couches (110) d'indice de réfraction complexe $n_1$ et m-1 deuxièmes couches (106) d'indice de réfraction complexe $n_2$ disposées de manière alternée les unes au-dessus des autres, m étant un nombre entier supérieur ou égal à 2.

5. Procédé selon l'une des revendications précédentes, dans lequel le calcul des paramètres de dépôt et de recuit des couches (104, 106) de l'empilement est mis en oeuvre, pour chaque couche (104, 106), à partir des valeurs des indices de réfraction complexes et des épaisseurs des couches (106, 110) obtenues en fonction de différents paramètres de dépôt et de recuit.

6. Procédé selon la revendication 5, dans lequel les paramètres de dépôt correspondent à une pression à laquelle les dépôts de couches (104, 106) sont mis en oeuvre, et/ou un débit gazeux de $SiH_4$ et/ou un rapport de débits gazeux de $N_2O$ et de $SiH_4$ lors des dépôts des couches (104, 106), et/ou une durée des dépôts et/ou de la puissance de l'équipement de dépôt utilisé.

7. Procédé selon l'une des revendications précédentes, dans lequel, lors du dépôt des couches (104, 106) de l'empilement, la ou les premières couches (104) de l'empilement sont réalisées telles qu'elles comportent en excès le semi-conducteur destiné à former les nanocristaux (108), le recuit étant mis en oeuvre ultérieurement aux dépôts et formant, dans la ou les premières couches (110), les nanocristaux de semi-conducteur (108) par précipitation à l'état solide du semi-conducteur présent en excès dans la ou les premières couches (104) déposées avant le recuit.

8. Procédé selon l'une des revendications précédentes, dans lequel la méthode de calcul de matrices de transfert optique comporte les étapes de :

   a) choix de valeurs arbitraires du nombre total de couches (106, 110) de l'empilement, des épaisseurs de chacune des couches (106, 110) de l'empilement et des valeurs des indices de réfraction complexes $n_1$ et $n_2$,
   b) calcul, pour chaque couche (106, 110) de l'empilement et pour chaque longueur d'onde de la fenêtre spectrale de réflectivité souhaitée, d'une matrice de transfert optique,
   c) calcul d'un produit matriciel des matrices de transfert optique précédemment calculées pour chacune des couches à l'étape b), correspondant à la matrice de transfert optique de l'empilement de couches (106, 110) ;

d) calcul de la réflectivité de l'empilement pour chaque longueur d'onde de la fenêtre spectrale de réflectivité souhaitée,

e) comparaison de la réflectivité calculée à l'étape d) et de la fenêtre spectrale de réflectivité souhaitée,

les étapes b) à e) étant répétées pour des valeurs différentes du nombre total de couches (106, 110) de l'empilement, des épaisseurs de chacune des couches (106, 110) de l'empilement et des indices de réfraction complexes $n_1$ et $n_2$ lorsque la réflectivité calculée à l'étape d) ne correspond pas à la fenêtre spectrale de réflectivité souhaitée.

9. Procédé de réalisation d'une cellule photovoltaïque (300) comportant la mise en oeuvre d'un procédé de réalisation d'au moins un premier réflecteur optique (306) selon l'une des revendications précédentes disposé en face avant de la cellule photovoltaïque (300) et formant une structure anti-réflective, et/ou la mise en oeuvre d'un procédé de réalisation d'au moins un deuxième réflecteur optique (308) selon l'une des revendications précédentes disposé en face arrière de la cellule photovoltaïque (300) et formant une structure réflective.

FIG.1A

FIG.1B

FIG.2

FIG.3

FIG.4

FIG.5

Europäisches
Patentamt

European
Patent Office

Office européen
des brevets

# RAPPORT DE RECHERCHE EUROPEENNE

Numéro de la demande

EP 12 18 1046

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | WO 2007/143227 A2 (QD VISION INC [US]; DOMASH LAWRENCE H [US]; COE-SULLIVAN SETH [US]; ST) 13 décembre 2007 (2007-12-13)<br>* page 1, alinéa 2 *<br>* page 3, alinéa 2 *<br>* page 4, alinéa 4 *<br>* page 7, alinéa 4 *<br>* page 11, alinéa 2 - page 12, alinéa 1 *<br>* page 15, alinéa 4 *<br>* page 18, alinéa 2-3 *<br>* page 22, alinéa 3 *<br>* page 23, alinéa 1 * | 1-9 | INV.<br>G02B1/11<br>B82Y20/00 |
| Y | MITSAS C L ET AL: "GENERALIZED MATRIX METHOD FOR ANALYSIS OF COHERENT AND INCOHERENT REFLECTANCE AND TRANSMITTANCE OF MULTILAYER STRUCTURES WITH ROUGH SURFACES, INTERFACES, AND FINITE SUBSTRATES",<br>APPLIED OPTICS, OPTICAL SOCIETY OF AMERICA, WASHINGTON, DC; US,<br>vol. 34, no. 10, 1 avril 1995 (1995-04-01), pages 1678-1683, XP000498526,<br>ISSN: 0003-6935, DOI: 10.1364/A0.34.001678<br>* le document en entier * | 1-9 | |
| | | | **DOMAINES TECHNIQUES RECHERCHES (IPC)**<br>G02B<br>B82Y |
| Y | KOVAC@?EVIC ET AL: "Silicon nanoparticles formation in annealed SiO/SiO2 multilayers",<br>PHYSICA E - LOW-DIMENSIONAL SYSTEMS AND NANOSTRUCTURES, ELSEVIER SCIENCE BV, NL,<br>vol. 38, no. 1-2,<br>14 avril 2007 (2007-04-14), pages 50-53,<br>XP022040484,<br>ISSN: 1386-9477, DOI:<br>10.1016/J.PHYSE.2006.12.023<br>* le document en entier * | 1-9 | |

-/--

Le présent rapport a été établi pour toutes les revendications

| Lieu de la recherche | Date d'achèvement de la recherche | Examinateur |
|---|---|---|
| Munich | 8 novembre 2012 | Denise, Christophe |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

Europäisches
Patentamt

European
Patent Office

Office européen
des brevets

## RAPPORT DE RECHERCHE EUROPEENNE

Numéro de la demande

EP 12 18 1046

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | YANCEY S ET AL:  "The influence of void space on antireflection coatings of silica nanoparticle self-assembled films", JOURNAL OF APPLIED PHYSICS, AMERICAN INSTITUTE OF PHYSICS. NEW YORK, US, vol. 99, no. 3, 15 février 2006 (2006-02-15), pages 34313-034313, XP012083759, ISSN: 0021-8979, DOI: 10.1063/1.2171784 * le document en entier * ----- | 1-9 | |
| | | | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| Munich | 8 novembre 2012 | Denise, Christophe |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
..............................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 12 18 1046

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

08-11-2012

| Document brevet cité au rapport de recherche | Date de publication | Membre(s) de la famille de brevet(s) | Date de publication |
|---|---|---|---|
| WO 2007143227 A2 | 13-12-2007 | US 2009251759 A1<br>WO 2007143227 A2 | 08-10-2009<br>13-12-2007 |

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2005064394 A1
- US 20020163003 A1